# EUROPEAN PATENT APPLICATION

(11) **EP 3 330 752 A1**
(43) Date of publication of application: **06.06.2018**
(21) Application number: 16830398.0
(22) Date of filing: 20.07.2016
(51) Int. Cl.: G02B 5/28, G02B 5/08, G02B 5/26, G21K 1/00, G21K 1/06

(54) **EUV LIGHT MULTI-LAYER MIRROR**

(30) Priority: 27.07.2015 JP 2015147484
(71) Applicant: NTT Advanced Technology Corporation, Kawasaki-shi, Kanagawa 212-0014 (JP)
(72) Inventor: ICHIMARU,Satoshi, Kawasaki-shi Kanagawa 212-0014 (JP); HATAYAMA,Masatoshi, Kawasaki-shi Kanagawa 212-0014 (JP); NISHIKINO,Masaharu, Shijonawate-shi Osaka 575-0001 (JP); ISHINO,Masahiko, Kizugawa-shi Kyoto 619-0223 (JP)
(74) Representative: Samson & Partner Patentanwälte mbB
(86) International application number: PCT/JP2016/071255
(87) International publication number: WO 2017/018293

(57) **Abstract**

To suppress the breakage of a mirror for reflecting high-intensity EUV light, an EUV multilayer mirror presenting a Bragg diffraction effect is formed by a pile of a plurality of heavy-element layers (102) and a plurality of light-element layers (103) disposed on a substrate (101), wherein the light-element layers and the heavy-element layers are alternately deposited. The heavy-element layers (102) contain niobium as a main component, and the light-element layers (103) contain silicon as a main component. For example, the heavy-element layers (102) made of niobium and the light-element layers (103) made of silicon are alternately deposited on the substrate (101) made of single-crystal silicon.

## Description

### Technical Field

The present invention relates to an EUV multilayer mirror which reflects high-intensity EUV light.

### Background Art

EUVL (Extreme Ultra Violet Lithography) using EUV (Extreme Ultra Violet) light having a wavelength of about 13.5 nm has been developed based on the diffraction principle that the focusing spot size of light can be decreased by shortening the wavelength of the light (see non-patent literature 1).

The refractive index of solid matter in the EUV region is extremely close to 1 and smaller than 1, so a mirror having a special structure must be used in diffraction and reflection compared to the visible light region. Therefore, a mirror having a reflecting surface coated with a multilayer film is used in a light-focusing optical system using EUV light (see non-patent literature 2).

This multilayer mirror is arranged near an EUV light source and used in a severe environment such as high-temperature, high-brilliance light irradiation exposure. When putting EUVL into practical use, therefore, one problem is to secure the long-term optical stability of the multilayer mirror. Multilayer mirrors having various structures have been proposed to solve this problem.

For example, when the multilayer mirror is used in a high-temperature environment, mutual diffusion or crystallization of elements forming layers occurs between the layers, and this deteriorates the performance of the mirror. As a method of suppressing this phenomenon, a highly heat-resistant multilayer film which includes a barrier layer formed between the layers using a highly heat-resistant material such as a carbide or oxide having a thickness of 0.1 to 0.3 nm has been proposed (see patent literatures 1, 2, 3, and 4, and non-patent literatures 3, 4, and 5). This technique has the drawback that the reflectance decreases because the barrier layer absorbs EUV light (see patent literature 4) .

Also, the multilayer film is used in a vacuum. The multilayer film surface is oxidized by a slight amount of oxygen contained in a vacuum and irradiation with EUV light or ultraviolet light, and as a consequence the reflectance decreases. As a method of suppressing this problem, each of non-patent literature 4 and non-patent literature 5, for example, has proposed a method of forming a multilayer film protective layer by using an anti-oxidation film such as an Ru film.

Furthermore, an anti-oxidation film having a catalyst effect for improving the anti-contamination performance, a technique which facilitates regeneration based on the assumption that the breakage of the multilayer mirror is unavoidable, and an EUV multilayer film in which a large number of layers are deposited to prolong the lifetime have been proposed (see patent literatures 4 and 5 and non-patent literature 6).

### Related Art Literature

### Patent Literature

Patent Literature 1: Japanese Patent Laid-Open No. 9-230098
Patent Literature 2: Japanese Patent Laid-Open No. 6-59098
Patent Literature 3: Japanese Patent Laid-Open No. 2008-090030
Patent Literature 4: Japanese Patent Laid-Open No. 2002-277589
Patent Literature 5: Japanese Patent Laid-Open No. 2006-170811
Patent Literature 6: Japanese Patent Laid-Open No. 2006-170813
Patent Literature 7: Japanese Patent Laid-Open No. 2005-098903
Patent Literature 8: Japanese Patent Laid-Open No. 2007-187987

### Non-Patent Literature

Non-Patent Literature 1: "Development and Application of EUV Light Source" compiled under Koichi Toyota and Shinji Okazaki, pages 3 to 17, CMC Publishing, published 2007.
Non-Patent Literature 2: "X-ray Imaging Optics" co-edited by Takeshi Namioka and Kojun Yamashita, pages 78 to 88, BAIFUKAN, published 1999.
Non-Patent Literature 3: H. Takenaka et al., "Heat-Resistance of Mo/Si Multilayer EUV Mirrors with Interleaved Carbon Barrier-Layers", OSA TOPS on EUVL, vol.4, pp.169-172, 1996.
Non-Patent Literature 4: S. Bajt et al., "Improved reflectance and stability of Mo/Si multilayers", Improved reflectance and stability of Mo/Si multilayers, vol.65, 2001.
Non-Patent Literature 5: S. Bajt et al., "Oxidation resistance of Ru-capped EUV multilayers", Proc. SPIE 5751, Emerging Lithographic Technologies IX, vol.118, 2005.
Non-Patent Literature 6: S. Ichimaru et al., "Mo/Si multilayer mirrors with 300-bilayers for EUV lithography", Photomask Japan 2015, 2015.
Non-Patent Literature 7: A.R. Khorsand et al., "Single shot damage mechanism of Mo/Si multilayer optics under intense pulsed XUV-exposure", OPTICS EXPRESS, vol.18, no.2, pp.700-712, 2010.
Non-Patent Literature 8: http://www.gigaphoton.com/news/gigaphoton, 140-w output by euv light source, duty cycle/

### Disclosure of Invention

### Problem to be Solved by the Invention

At present, a phenomenon called ablation by which a metal is burned down by heat generated when a substance absorbs high-brilliance light has posed a problem. For this phenomenon which is not a problem for conventionally-used-intensity EUV light, there are several reports such as examination of the threshold value of light intensity at which ablation occurs. For example, non-patent literature 7 describes that ablation damages an Mo/Si multilayer film when the luminance of incident EUV light exceeds 45 mJ/cm².

On the other hand, the luminance of an EUV light source has dramatically increased. The output of an LPP (Laser Produced Plasma) light source has increased to 150 W (non-patent literature 8). As an XFEL (X-ray Free-Electron Laser), an EUV light source concept having an output of 10 kW has been proposed in LCLS (Linac Coherent Light Source)-II project. Furthermore, EUV light which repeats 20.8 MHz at a high-order harmonic is generated, and this has dramatically increased the light intensity per unit area.

The intensities of these light sources are orders of magnitude higher than those of the conventionally used light sources, and the breakage of a mirror for reflecting high-intensity EUV light like this has posed a more significant problem.

The present invention has been made to solve the problems as described above, and has as its object to suppress the breakage of a mirror for reflecting high-intensity EUV light.

### Means of Solution to the Problem

An EUV multilayer mirror according to the present invention is formed by a pile of a plurality of light-element layers and a plurality of heavy-element layers, wherein the light-element layers and the heavy-element layers are alternately deposited, the EUV multilayer mirror presenting a Bragg diffraction effect, wherein the light-element layers contain silicon as a main component, and the heavy-element layers contain niobium as a main component.

In the abovementioned EUV multilayer mirror, the light-element layers are made of silicon, and the heavy-element layers are made of niobium.

### Effect of the Invention

In the present invention as explained above, the light-element layers contain silicon as a main component, and the heavy-element layers contain niobium as a main component. Consequently, a remarkable effect of suppressing the breakage of a mirror for reflecting high-intensity EUV light is obtained.

### Brief Description of Drawings

Fig. 1 is a sectional view showing a partial structure of an EUV multilayer mirror according to an embodiment of the present invention;
Fig. 2 is a graph showing the calculation result of the reflection characteristic of the multilayer mirror when light enters at an incidence angle of 45°;
Fig. 3A is a view for explaining the result of observation on the state of damage to a multilayer mirror of Comparative Example 1 when high-brilliance EUV light enters;
Fig. 3B is a view for explaining the result of observation on the state of damage to the multilayer mirror according to the embodiment when high-brilliance EUV light enters;
Fig. 4A is a view for explaining the result of observation on the state of damage to the multilayer mirror of Comparative Example 1 when high-brilliance EUV light enters;
Fig. 4B is a view for explaining the result of observation on the state of damage to the multilayer mirror according to the embodiment when high-brilliance EUV light enters; and
Fig. 5 is a view showing the arrangement of an optical apparatus using the EUV multilayer mirror.

### Best Mode for Carrying Out the Invention

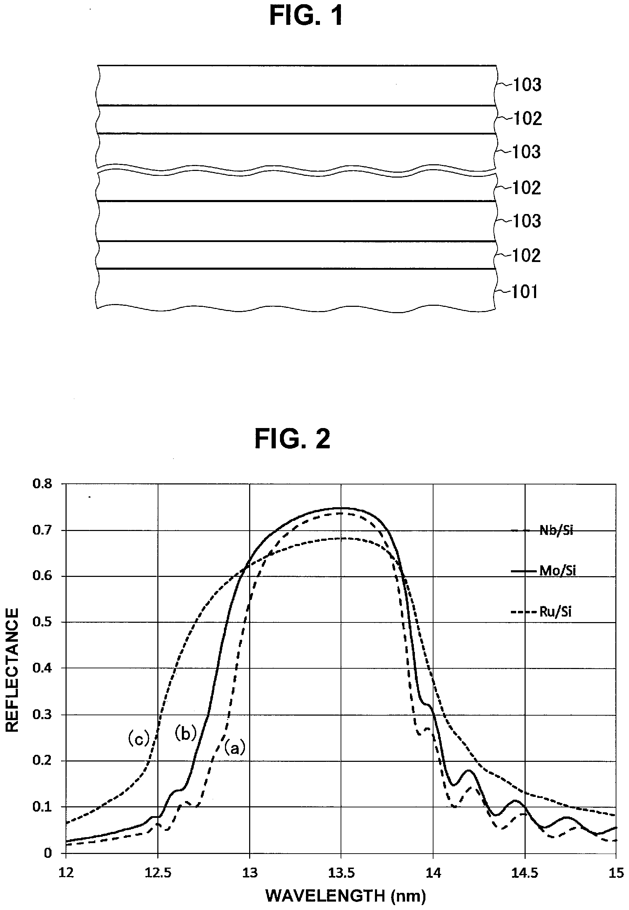

An embodiment of the present invention will be explained below with reference to the accompanying drawings. Fig. 1 is a sectional view showing a partial structure of an EUV multilayer mirror according to the embodiment of the present invention. This EUV multilayer mirror is an EUV multilayer mirror formed by a pile, disposed on a substrate 101, of a plurality of heave-element layers 102 and a plurality of light-element layers 103 which are alternately deposited, and the EUV multilayer mirror presents a Bragg diffraction effect. Also, the heavy-element layers 102 contain niobium as a main component, and the light-element layers 103 contain silicon as a main component. For example, the heavy-element layers 102 made of niobium and the light-element layers 103 made of silicon are alternately deposited on the substrate 101 made of single-crystal silicon.

The heavy-element layer 102 made of niobium has a thickness of about 4 nm, and the light-element layer 103 made of silicon has a thickness of 6 nm. Also, 80 pairs of the heavy-element layers 102 and light-element layers 103 are deposited. Each layer can be formed by depositing the material by magnetron sputtering or the like.

Next, the reflection characteristic of the EUV multilayer mirror having the above-described structure will be explained with reference to Fig. 2. Fig. 2 is a graph showing the calculation result of the reflection characteristic when light enters at an incidence angle of 45°. For comparison, Fig. 2 also shows the calculation result of the reflection characteristic of Comparative Example 1 in which heavy-element layers made of molybdenum and light-element layers made of silicon are alternately deposited on a substrate made of single-crystal silicon, and the calculation result of the reflection characteristic of Comparative Example 2 in which heavy-element layers made of ruthenium and light-element layers made of silicon are alternately deposited on a substrate made of single-crystal silicon. In each structure, the heavy-element layer has a thickness of 4 nm, the light-element layer has a thickness of 6 nm, and 80 pairs of the heavy-element layers and light-element layers are deposited.

In Fig. 2, (a) indicates the reflection characteristic of the EUV multilayer mirror according to the embodiment, (b) indicates the reflection characteristic of the EUV multilayer mirror according to Comparative Example 1, and (c) indicates the reflection characteristic of the EUV multilayer mirror according to Comparative Example 2. As shown in Fig. 2, conventionally used Comparative Example 1 has the highest reflectance. Fig. 2 also shows that the EUV multilayer mirror according to the embodiment can have a reflectance of about 98% of that of Comparative Example 1 at a wavelength of 13.5 nm.

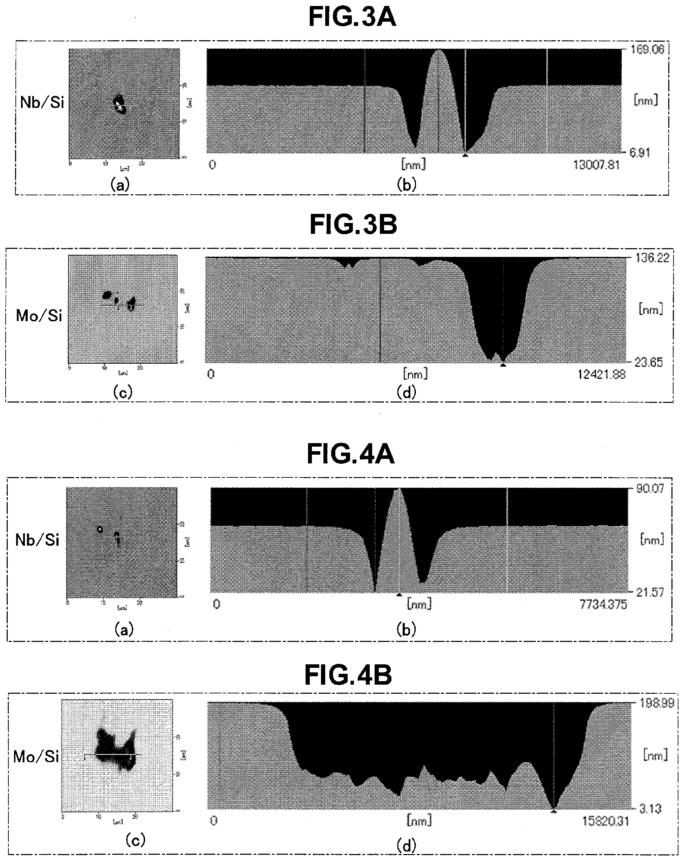

The results of observation on the state of damage when high-brilliance EUV light was actually incident will be explained below. In the following explanation, the results obtained when high-brilliance EUV light entered the EUV multilayer mirror according to the embodiment and on Comparative Example 1 will be described. This observation was performed using an atomic force microscope. Figs. 3A and 3B show the results obtained when EUV light having a wavelength of 13.9 nm and a light intensity of 20 mJ/cm² entered the surface of the multilayer mirror almost perpendicularly at an incidence angle of 6°.

In Comparative Example 1, damage reaches a depth of 110 nm at a maximum as indicated by (d) in Fig. 3B in a 10 µm × 5 µm region as indicated by (c) in Fig. 3B. By contrast, in the EUV multilayer mirror according to the embodiment, damage reaches a depth of 40 nm at a maximum as indicated by (b) in Fig. 3A in a 5 µm × 5 µm region as indicated by (a) in Fig. 3A. Thus, damage is smaller in the EUV multilayer mirror according to the embodiment.

Figs. 4A and 4B show the results obtained when EUV light having a wavelength of 13.9 nm and a light intensity of 30 mJ/cm² entered at an incidence angle of 6° in the same manner as in Figs. 3A and 3B. In Comparative Example 1, damage reaches a depth of 190 nm at a maximum as indicated by (d) in Fig. 4B in a 10 µm × 10 µm region as indicated by (c) in Fig. 4B. By contrast, in the EUV multilayer mirror according to the embodiment, damage reaches a depth of 100 nm at a maximum as indicated by (b) in Fig. 4A in a 5 µm × 5 µm region as indicated by (a) in Fig. 4A. Thus, damage is smaller in the EUV multilayer mirror according to the embodiment even in high-intensity EUV irradiation.

These results reveal that the EUV multilayer mirror according to the embodiment has durability twice that of the conventional multilayer mirror in which heavy-element layers made of molybdenum and light-element layers made of silicon are alternately deposited. The results explained with reference to Figs. 3A, 3B, 4A, and 4B are results obtained under the conditions that EUV light entered at an incidence angle of 6° different from the designed reflection angle (45°) of the multilayer mirror, and the incident EUV light was entirely absorbed by the multilayer film. On the other hand, the results described in non-patent literature 7 are results obtained under the conditions that the incidence angle was an angle at which 70% of radiated EUV light were reflected and were not absorbed in the multilayer film. In Comparative Example 1 shown Figs. 3A and 4A, therefore, damage occurred even when EUV light was radiated at intensity (illuminance) lower than the damage threshold described in non-patent literature 7. When the results shown in Figs. 3A, 3B, 4A, and 4B are converted into the results of non-patent literature 7 by taking account of these factors, the damage threshold of Comparative Example 1 is 45 mJ/cm², whereas the EUV multilayer mirror according to the embodiment presumably has a damage threshold of 90 to 130 mJ/cm².

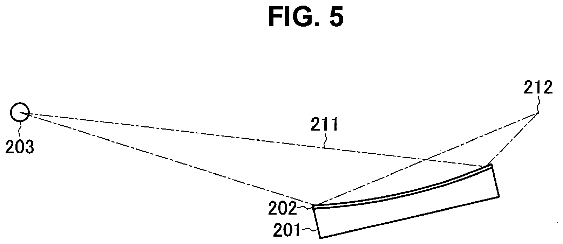

An optical apparatus using the EUV multilayer mirror according to the embodiment having a high durability as described above will be explained with reference to Fig. 5. This optical apparatus includes an EUV multilayer mirror 202 according to the embodiment formed on a substrate 201, and a point light source 203. The EUV multilayer mirror 202 forms a concave mirror.

EUV light 211 emitted by the point light source 203 is reflected by the EUV multilayer mirror 202, and focused to a light focus point 212. The use of the EUV multilayer mirror 202 according to the embodiment makes it possible to suppress the peeling of layers forming the EUV multilayer mirror 202 caused by irradiation with the high-brilliance EUV light 211 emitted from the point light source 203, and provide an optical apparatus having a long lifetime and high durability.

In the present invention as has been explained above, an EUV multilayer mirror having a Bragg diffraction effect is formed by a pile of a plurality of light-element layers containing silicon as a main component and a plurality of heavy-element layers containing niobium as a main component, wherein the light-element layers and the heavy-element layers are alternately deposited. This makes it possible to suppress the breakage of a mirror for reflecting high-intensity EUV light. As a consequence, according to the present invention and the embodiment of the invention, it is possible to prolong the lifetime of a mirror, thereby achieving a long maintenance cycle and low cost of an optical apparatus using this mirror, and reducing the cost of a part to be processed by the apparatus. The EUV multilayer mirror of the present invention is applicable to a processing apparatus using EUV light, and an analyzing apparatus and evaluating apparatus for analyzing the composition and structure of a semiconductor material, analyzing the structure of a soft material such as protein, and performing drug discovery pathologic examination.

Note that the present invention is not limited to the embodiment explained above, and it is obvious that those skilled in the art can make many modifications and combinations within the technical scope of the invention. For example, the method of forming each layer is not limited to magnetron sputtering, and it is also possible to use another sputtering method such as ECR (Electron Cyclotron Resonance) sputtering, or another deposition method such as vacuum vapor deposition. Furthermore, the heat resistance can be increased by forming an barrier layer using a highly heat-resistant material such as a carbide or oxide between each light-element layer and each heavy-element layer.

### Explanation of the Reference Numerals and Signs

101...substrate, 102...heavy-element layer, 103...light-element layer.

## Claims

1. An EUV multilayer mirror formed by a pile of a plurality of light-element layers and a plurality of heavy-element layers, wherein the light-element layers and the heavy-element layers are alternately deposited, the EUV multilayer mirror presenting a Bragg diffraction effect,
wherein the light-element layers contain silicon as a main component, and
the heavy-element layers contain niobium as a main component.

2. The EUV multilayer mirror according to claim 1, wherein
the light-element layers are made of silicon, and
the heavy-element layers are made of niobium.
